# EUROPÄISCHE PATENTSCHRIFT

(11) **EP 0 396 553 B1**
(45) Veröffentlichungstag und Bekanntmachung des Hinweises auf die Patenterteilung: **01.06.1994**
(21) Anmeldenummer: 88908940.5
(22) Anmeldetag: 24.10.1988
(51) Int. Cl.: H01L 27/08

(54) **INTEGRIERTE SCHALTUNG MIT ''LATCH-UP''-SCHUTZSCHALTUNG IN KOMPLEMENTÄRER MOS-SCHALTUNGSTECHNIK**
INTEGRATED CIRCUIT WITH ANTI ''LATCH-UP'' CIRCUIT OBTAINED USING COMPLEMENTARY MOS CIRCUIT TECHNOLOGY
CIRCUIT INTEGRE A CIRCUIT DE PRODUCTION ANTI-''LATCH-UP'' REALISE SELON LA TECHNIQUE DES CIRCUITS CMOS

(30) Priorität: 23.12.1987 DE 3743930
(43) Veröffentlichungstag der Anmeldung: 14.11.1990
(73) Patentinhaber: SIEMENS AKTIENGESELLSCHAFT, 80333 München (DE)
(72) Erfinder: RECZEK, Werner, D-8000 München 90 (DE); PRIBYL, Wolfgang, D-8012 Ottobrunn (DE)
(86) Internationale Anmeldenummer: DE8800651
(87) Internationale Veröffentlichungsnummer: WO8906048

(56) Entgegenhaltungen:
- EP-A- 0 166 386
- PATENT ABSTRACTS OF JAPAN, vol. 8, no. 78, (E-237)(1515), 10 April 1984 ; & JP-A-58225664
- PATENT ABSTRACTS OF JAPAN, vol. 10, no. 302, (E-445)(2358), 15 October 1986 ; & JP-A-61115349
- PATENT ABSTRACTS OF JAPAN, vol. 11, no. 325, (E-551)(2772), 22 October 1987 ; & JP-A-62112360

## Beschreibung

Die Erfindung bezieht sich auf eine integrierte Schaltung mit "Latch-up"-Schutzschaltung in komplementärer MOS-Schaltungstechnik nach dem Oberbegriff des Patentanspruchs 1.

Bei integrierten Schaltungen dieser Art in komplementärer MOS-Technologie treten parasitäre pnpn-Pfade zwischen der Versorgungsspannung und der Masse auf, die einem Thyristor ähnlich sind. Diese parasitäre Vierschichtstruktur kann durch Störungen, beispielsweise durch Stromimpulse oder durch Über- oder Unterschwinger der angelegten Versorgungsspannung an den Halbleiterschichten gezündet werden. Der Übergang vom Normalzustand in einen hochleitenden Zustand, d.h. das Zünden dieser Vierschichtstruktur, wird als "Latch-Up" bezeichnet.

Zum Verständnis des "Latch-Up"-Effekts kann man davon ausgehen, daß zwischen einem Anschluß eines in einer wannenförmigen Halbleiterzone liegenden Feldeffekttransistors des ersten Kanaltyps und einem Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmigen Halbleiterzone die zweite, das Halbleitersubstrat die dritte und das eine Anschlußgebiet des letzten Transistors die vierte Halbleiterschicht bilden. Aufgrund dieses Aufbaus ergeben sich ein parasitärer bipolarer pnp- und ein npn-Transistor. Der Kollektor des pnp-Bipolartransistors entspricht der Basis des npn-Bipolartransistors und die Basis des pnp-Bipolartransistors dem Kollektor des npn-Bipolartransistors. Diese Struktur bildet eine Vierschichtdiode der Schichtenfolge pnpn wie bei einem Thyristor. Bei einer positiven Vorspannung des Halbleitersubstrats kann der pn-Übergang zwischen der dritten und vierten Halbleiterschicht soweit in Durchlaßrichtung vorgespannt werden, daß zwischen den genannten Transistoranschlüssen ein Strompfad entsteht, der auf eine parasitäre Thyristorwirkung innerhalb dieser Vierschichtstruktur zurückzuführen ist. Der Strompfad bleibt dann auch nach einem Abbau der positiven Substratvorspannung bestehen und kann die integrierte Schaltung thermisch überlasten.

Der "Latch-Up"-Effekt ist in dem Fachbuch Halbleiterelektronik 14, H.Weiß, K.Horninger "Integrierte MOS-Schaltungen" auf den Seiten 109-112 beschrieben. Bild 3.6. auf Seite 109 zeigt hierfür ein komplementäres Transistorpaar in Massivsilizium, wobei in Bild 3.7c zusätzlich die parasitären, lateralen und vertikalen Bipolartransistoren aufgezeichnet sind, welche für den "Latch-Up"-Effekt von entscheidender Bedeutung sind.

Bisher wurde versucht, das "Latch-up"-Problem der besonders von diesem Effekt betroffenen Bereiche in einer integrierten Schaltung, wie beispielsweise Datenausgänge und Ausgangsstufen, auf drei verschiedenen Lösungswegen zu verringern. Zum einen wurde versucht, bei CMOS-Ausgangsstufen das Potential der wannenförmigen Halbleiterzone zu "boosten", dies bedeutet, das Potential der wannenförmigen Halbleiterzone, die beispielsweise n-dotiert ist, wird über die Versorgungsspannung V_{DD} angehoben. Bei dieser ersten Lösungsmöglichkeit wird die wannenförmige Halbleiterzone also mit einem festen Potential verbunden, welches ein zusätzlicher Wannenvorspannungsgenerator liefern muß oder extern durch einen zusätzlichen Anschluß angelegt wird. Die zweite Lösungsmöglichkeit sieht die Verwendung von reinen NMOS-Ausgangsstufen vor, wobei ein zusätzlicher Wannenvorspannungsgenerator wie in der ersten Lösungsmöglichkeit nicht erforderlich ist. Hierbei wird mit Hilfe einer Substratvorspannung am Halbleitersubstrat versucht, die Möglichkeit eines "Latch-up" während des Betriebs der integrierten Schaltung auszuschließen. Eine dritte Lösungsmöglichkeit ergibt sich durch die Verwendung einer "floatenden" wannenförmigen Halbleiterzone, wie sie in der Veröffentlichung von H.P. Zappe et al. "Floating well CMOS and "Latch-Up", IEDM 85, S. 517 - 520 vom 09.12.1985 beschrieben ist. Die wannenförmige Halbleiterzone ist in diesem Fall nur über die parasitären Source-Drain-pn-Übergänge des in der wannenförmigen Halbleiterzone liegenden MOS-Transistors mit der "Außenwelt" verbunden, wodurch kein Basisstrom durch den parasitären vertikalen Bipolartransistor fließen kann.

Die zuletzt genannte Lösungsmöglichkeit bedingt den Nachteil, daß sich die MOS-Transistorparameter verschlechtern, die Leckströme über die wannenförmige Halbleiterzone erhöhen und sich die Haltespannung des parasitären pnpn-Übergangs verringert. Durch die Verwendung von reinen NMOS-Ausgangsstufen ergeben sich unbefriedigende Schaltungseigenschaften, zum Beispiel in der Schaltgeschwindigkeit, sowie Pegelprobleme im High-Zustand des Ausgangssignals. Letztere können zwar durch "Boosten" des Ausgangssignals umgangen werden, was jedoch wiederum zusätzlichen Aufwand und erhöhten Platzbedarf erfordert. Gegen die erste Lösungsmöglichkeit mit Hilfe eines Wannenvorspannungsgenerators die Möglichkeit eines "Latch-Ups" zu verringern, spricht die zusätzlich notwendige Verdrahtung sowie ein zusätzlicher Flächenbedarf für diesen Generator.

In den Patent Abstracts of Japan, Band 8, Nr. 78, (E-237) (1515) 10. April 1984 und in der japanischen Patentanmeldung JP-A-58 225 664 (SANYO DENKI K. K.), 27. Dezember 1983 ist eine Schutzstruktur mit einem Bypaßtransistor beschrieben, dessen Source-Gebiet durch einen Teil einer p-dotierten Wanne, dessen Kanal-Gebiet durch einen Teil eines n-dotierten Substrats und dessen Drain-Gebiet durch ein p-dotiertes Gebiet gebildet wird, das die p-dotierte Wanne ringförmig umgibt. Nachteilig ist hierbei der erhöhte Flächenbedarf auf Grund des ringförmigen Gebiets und die schlechte Einstellbarkeit der Durchlaßspannung des Bypaßtransistors.

Die Tatsache, daß mit Hilfe variabler Wannen- und Substratvorspannungen die Schwellenspannungen bei CMOS-Schaltkreisen einstellbar sind, ist an sich aus den Patent Abstracts of Japan, Bd. 10, Nr. 302 (E445) (2358) 15. Oktober 1986 und aus der japanischen Patentanmeldung JP-A-61 115 349 (MITSUBISHI ELECTRIC CORP.), 02. Juli 1986, bekannt.

Der Erfindung liegt die Aufgabe zugrunde, eine Schaltung der eingangs genannten Art anzugeben, bei der das Auftreten von "Latch-Up"-Effekten weitgehend vermieden wird. Das wird erfindungsgemäß durch eine Ausbildung der Schaltung nach dem kennzeichnenden Teil des Patentanspruchs 1 erreicht.

Die Patentansprüche 2 bis 7 sind auf bevorzugte Ausgestaltungen und Weiterbildungen der Erfindung gerichtet.

Der mit der Erfindung erzielbare Vorteil liegt insbesondere darin, daß durch die erfinderische Schaltung die Schaltungseigenschaften der MOS-Transistoren nicht beeinflußt werden und die erfinderische Schaltung sowohl für wannenförmige Halbleiterzonen mit einem festen Potential als auch für wannenförmige Halbleiterzonen mit variablem Potential geeignet ist. Weiterhin ist der Platzbedarf für die erfinderische Schaltung sehr gering, da hierfür nur ein zusätzliches Schaltungselement benötigt wird.

Zwei Ausführungsbeispiele der Erfindung sowie eine Realisierungsmöglichkeit sind in den Zeichnungen in der Figur 2, 4 und 5 dargestellt und werden im folgenden näher beschrieben. Es zeigt:
- Figur 1: ein Ersatzschaltbild einer Ausgangsstufe mit Bypaßtransistor,
- Figur 2: einen Querschnitt durch eine CMOS-Ausgangsstufe mit CMOS-Ausgangstransistoren, bei der die wannenförmige Halbleiterzone mit einem festen Potential verbunden ist,
- Figur 3: ein Ersatzschaltbild durch einen als Diode oder Lastelement beschalteten p-Kanal-MOS-Transistor mit Bypaßtransistor,
- Figur 4: einen Querschnitt durch einen als Diode oder Lastelement beschalteten p-Kanal-MOS-Transistor mit Bypaßtransistor, bei der die wannenförmige Halbleiterzone nicht mit einem festen Potential verbunden ist,
- Figur 5: eine Realisierung eines als Diode oder Lastelement beschalteten p-Kanal-MOS-Transistors mit Bypaßtransistor nach der in Figur 3 und Figur 4 angegebenen Schaltung.

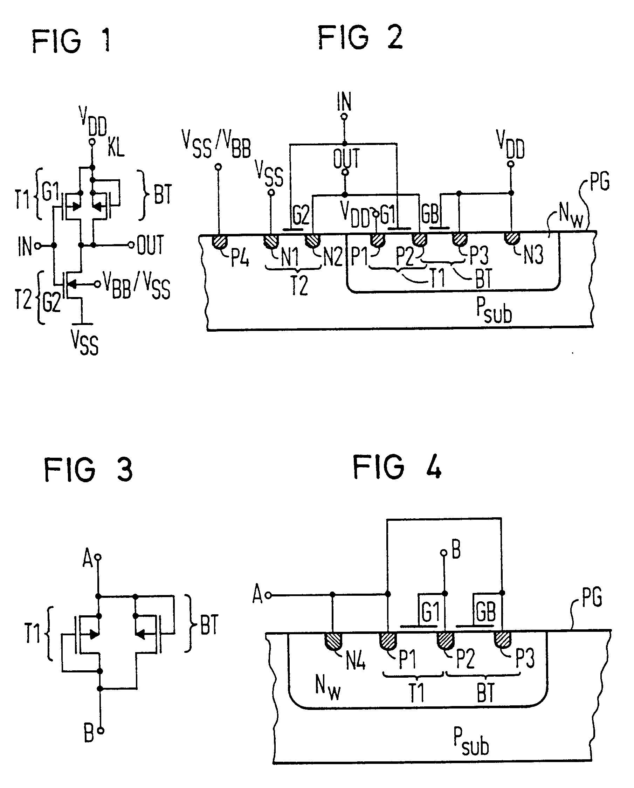

Figur 1 zeigt das Ersatzschaltbild einer CMOS-Ausgangsstufe mit einem Bypaßtransistor BT. Eine vorhandene Klemme KL ist hierbei mit der Versorgungsspannung V_{DD} beschaltet. Die CMOS-Ausgangsstufe enthält zwei in Serie geschaltete komplementäre Feldeffekttransistoren T1 und T2, wobei der p-Kanal-Feldeffekttransistor T1 mit seinem Source- und Substratanschluß an die Versorgungsspannung V_{DD} gelegt ist und der n-Kanal-Feldeffekttransistor T2 mit seinem Sourceanschluß mit der Masse V_{SS} verschaltet ist. Die Gateanschlüsse G1, G2 des p-Kanal-Feldeffekttransistors T1 und des n-Kanalfeldeffekttransistors T2 bilden gemeinsam den Eingang IN der CMOS-Ausgangsstufe, während die Drainanschlüsse des p-Kanal-Feldeffekttransistors T1 und des n-Kanal-Feldeffekttransistors T2 mit dem Ausgang OUT verbunden sind. Der Substratanschluß des n-Kanal-Feldeffekttransistors T2 kann wahlweise auf eine Substratvorspannung oder mit der Masse V_{DD}/V_{SS} angeschlossen werden.

Der erfindungswesentliche Teil der CMOS-Ausgangsstufe betrifft den Einbau des Bypaßtransistors BT, der positive Überspannungen von dem Ausgang OUT auf die Versorgungsspannung V_{DD} weiterleitet. Hierfür ist der Source-, Substrat- und Gateanschluß des p-Kanal-Bypaßtransistors BT mit der Versorgungsspannung V_{DD} und der Drainanschluß ist mit dem Ausgang OUT verbunden. Im Normalbetrieb, wenn keine Überspannungen auftreten, sperrt der Bypaßtransistors BT. Wenn positive Überspannungen am Ausgang OUT anliegen, die größer sind als die Summe aus der Versorgungsspannung V_{DD} und der Durchflußspannung des Bypaßtransistors wird der Bypaßtransistor BT leitend und die positive Überspannung am Ausgang OUT wird abgebaut. Der Bypaßtransistor BT saugt dabei zusätzlich Ladungsträger ab und erhöht dadurch den zum Auftreten von "Latch-Up" notwendigen Triggerstrom in den parasitären Bipolartransistoren.

Einen Querschnitt zu der in Figur 1 dargestellten CMOS-Ausgangsstufe ist in der Figur 2 wiedergegeben. Innerhalb eines Halbleitersubstrats P_{sub} aus dotiertem Halbleitermaterial, z.B. aus p-leitendem Silizium, ist eine n-leitende wannenförmige Halbleiterzone N_{w} eingefügt, die sich bis zur Grenzfläche PG hin erstreckt. Außerhalb der wannenförmigen Halbleiterzone N_{w} sind in dem Halbleitersubstrat n⁺-dotierte Halbleitergebiete N1, N2 eingefügt, die das Source- und Draingebiet eines n-Kanal-Feldeffekttransistors T2 bilden, während innerhalb der wannenförmigen Halbleiterzone N_{w} drei p⁺-dotierte Halbleitergebiete P1, P2 und P3 vorhanden sind, die die Source- und Drainbereiche des p-Kanal-Feldeffekttransistors T1 und des p-Kanal-Bypaßtransistors BT darstellen. Das p⁺-dotierte Halbleitergebiet P1 wird für den Sourceanschluß des p-Kanal-Feldeffekttransistors P1 und das p⁺-dotierte Halbleitergebiet P3 für den Sourceanschluß des p-Kanal-Bypaßtransistors BT genutzt, das p⁺-dotierte Halbleitergebiet P2 bildet den gemeinsamen DrainanschluB des p-Kanal-FeldeffekttransistorS T1 und des p-Kanal-Bypaßtransistors BT. Im angegebenen Beispiel der Figur 2 sind die Feldeffekttransistoren T1 und T2 als eine CMOS-Ausgangsstufe aufgebaut, wobei das n⁺-dotierte Halbleitergebiet N1 als Sourceanschluß des n-Kanal-Feldeffekttransistors T2 mit der Masse V_{SS} verschaltet ist und das n⁺-dotierte Halbleitergebiet N2 als Drainanschluß des n-Kanal-Feldeffekttransistors T2 den Ausgang OUT der CMOS-Ausgangsstufe bildet. Das p⁺-dotierte Halbleitergebiet P2 ist ebenfalls an den Ausgang OUT gelegt, während das p⁺-dotierte Halbleitergebiet P1 als Sourceanschluß desselben Feldeffekttransistors mit der Versorgungsspannung V_{DD} verschaltet ist. Ein Eingangssignal für die CMOS-Ausgangsstufe wird über den Eingang IN auf ein erstes und zweites Gategebiet G1 und G2 des ersten bzw. zweiten Feldeffekttransistors T1, T2 weitergeleitet, während ein Ausgangssignal am Ausgang OUT abgreifbar ist. Das p⁺-dotierte Halbleitersubstrat P_{sub} ist, wie in Figur 2 eingezeichnet, über ein zusätzlich p⁺-dotiertes Halbleitergebiet P4 mit der Masse oder mit einer Substratvorspannung V_{SS}/ V_{BB} verbunden, während die n-leitende wannenförmige Halbleiterzone N_{w} über ein n⁺-dotiertes Halbleitergebiet N3 mit der Versorgungsspannung V_{DD} beschaltet ist.

Den erfindungswesentlichen Teil der CMOS-Ausgangsstufe stellt der Einbau des p-Kanal-Bypaßtransistors BT zwischen dem Ausgang OUT und der Versorgungsspannung V_{DD} dar. Hierzu ist der Drainanschluß des Bypaßtransistors, der durch das p⁺-dotierte Halbleitergebiet P2 gebildet wird, mit dem Ausgang OUT und der Sourceanschluß, realisiert durch das p⁺-dotierte Halbleitergebiet P3, und der Gateanschluß GB gemeinsam mit der Versorgungsspannung V_{DD} verschaltet. Man erkennt, daß der Bypaßtransistor BT auf relativ einfache Weise durch eine zusätzliche p⁺-Diffusion für das p⁺-dotierten Halbleitergebiet P3 und durch ein zusätzliches MOS-Gate GB realisiert werden kann. Der Drainanschluß des Bypaßtransistors BT stellt das p⁺-dotierte Halbleitergebiet P2 dar, welches ebenfalls als Drainanschluß für den p-Kanal-Feldeffekttransistor T1 genutzt wird.

Die Gefahr eines "Latch-Up"-Effekts ist in Figur 2 durch die pnpn-Struktur zwischen dem n⁺-leitenden Halbleitergebiet N1, dem p-dotierten Halbleitersubstrat P_{sub}, der n-leitenden wannenförmigen Halbleiterzone N_{w} und dem p⁺-dotierten Halbleitergebiet P2 immer dann gegeben, wenn einer der pn-Übergänge in Durchlaßrichtung gepolt wird. In diesem Falle kann die pnpn-Struktur, die einer Vierschichtdiode ähnelt, wie bei einem Thyristor gezündet werden. Es fließt dann ein so hoher Strom über die pn-Übergänge, daß entweder die Übergänge oder die Zuleitungen durchschmelzen, was zu einer Zerstörung der CMOS-Ausgangsstufe führen kann. Durch den Einbau des zusätzlichen p-Kanal-Bypaßtransistor BT werden positive Überspannung, die am Ausgang OUT auftreten, und am p⁺-dotierten Halbleitergebiet P2 anliegen, immer dann über den p-Kanal-Bypaßtransistor BT zur Versorgungsspannung V_{DD} abgeführt, wenn die Größe der Überspannung die Summe aus der Versorgungsspannung V_{DD} und der Durchlaßspannung des Bypaßtransistors übersteigt. Der Bypaßtransistor BT saugt, wie in Figur 1 bereits erwähnt, die zusätzlichen Ladungsträger ab und erhöht hiermit den zum Auftreten von "Latch-Up"-Effekten notwendigen Triggerstrom. Wichtig dabei ist, daß der Bypaßtransistor BT eine Durchlaßspannung besitzt, die geringer ist als die Durchlaßspannung der pn-Übergänge des p-Kanal-Feldeffekttransistors T1.

Zur Verringerung der "Latch-Up"-Gefährdung ist der Bypaßtransistor BT besonders dann geeignet, wenn die n-leitende wannenförmige Halbleiterzone N_{w} eines als Lastelement oder als Diode geschalteten p-Kanal-MOS-Transistors nicht auf einem ersten Potential, beispielsweise auf der Versorgungsspannung V_{DD}, sondern aus schaltungstechnischen Gründen auf variablem Potential liegt. Figur 3 zeigt ein Ersatzschaltbild eines derart beschalteten MOS-Transistors T1. Dem zwischen den Klemmen A und B geschalteten p-Kanal-Feldeffekttransistor T1 ist nach Figur 3 ein p-Kanal-Bypaßtransistor BT parallel geschaltet. Hierzu ist ein erster Anschluß sowie der Substratanschluß des p-Kanal-Feldeffekttransistors T1 und das Gategebiet und ein erster Anschluß des p-Kanal-Bypaßtransistors BT sowie sein Substratanschluß mit der Klemme A und ein zweiter Anschluß und der Gateanschluß des p-Kanal-Feldeffekttransistors T1 und ein zweiter Anschluß des Bypaßtransistors BT mit der Klemme B verbunden. Im Normalbetrieb liegt die Klemme A auf einem positiven und die Klemme B auf einem negativen Potential. Hierbei kann ein parasitärer vertikaler Bipolartransistor nicht aktiviert werden und zu einem "Latch-Up" führen. Erhält bei Störungen oder beim Schalten von übrigen Schaltungselementen der integrierten Schaltung die Klemme B ein positiveres Potential als die Klemme A, so ist das Auftreten von "Latch-Up" immer dann unvermeidlich, wenn die Klemme B ein Potential aufweist, welches größer ist als die Summe des Potentials an Klemme A und der Durchlaßspannung des pn-Übergangs vom p-Kanal-Feldeffekttransistor T1 (ca. 0,7 Volt). Durch den zusätzlichen Einbau des Bypaßtransistors BT wird dieser leitend, wenn die Spannung an der Klemme B großer wird als die Summe aus der Durchlaßspannung des Bypaßtransistors und der Spannung an der Klemme A. In diesem Falle ist die Klemme A niederohmig mit der Klemme B verbunden. Das Auslösen von "Latch-Up" durch eine Aktivierung eines vertikalen parasitären Bipolar-Transistors wird somit erschwert.

Eine Realisierung des in Figur 3 angegebenen Ersatzschaltbildes zeigt Figur 4. Hierbei ist die n-leitende wannenförmige Halbleiterzone N_{w}, die innerhalb der p⁺-dotierten Halbleiterzone P_{sub} eingebettet ist, nicht wie in der Figur 2 mit einem festen Potential, sondern mit einem variablen Potential über das n⁺-dotierte Halbleitergebiet N4 mit der Klemme A verbunden.

Die leitende wannenförmige Halbleiterzone N_{w} erstreckt sich ebenso wie in Figur 2 bis zur Grenzfläche PG und beinhaltet den p-Kanal-Feldeffekttransistor T1 sowie den parallel geschalteten p-Kanal-Bypaßtransistors BT. Der p-Kanal-Feldeffekttransistor T1 ist aus den beiden p⁺-dotierten Halbleitergebieten P1 und P2 sowie aus dem Gategebiet G1 aufgebaut, wobei das p⁺-dotierte Halbleitergebiet P1, welches einen ersten Anschluß des p-Kanal-Feldeffekttransistors T1 darstellt, mit der Klemme A verbunden ist, und das p⁺-dotierte Halbleitergebiet P2, welches den zweiten Anschluß des p-Kanal-Feldeffekttransistors T1 darstellt, ist mit dem Gategebiet G1 an der Klemme B angeschlossen. Der parallel geschaltete Bypaßtransistor ist mit Hilfe des p⁺-dotierten Halbleitergebiets P2 und P3 sowie mit dem Gategebiet GB realisiert, wobei das p⁺-dotierte Halbleitergebiet P3 den ersten AnschluB des Bypaßtransistors darstellt und mit dem Gategebiet GB und der Klemme A verbunden ist, und daß p⁺-dotierte Halbleitergebiet P2 den zweiten Anschluß des Bypaßtransistors darstellt. Das p⁺-dotierte Halbleitergebiet P2 erfüllt somit eine Doppelfunktion. Zum einen stellt es den zweiten Anschluß des p-Kanal-Feldeffekttransistors T1 dar und zum anderen bildet es den zweiten Anschluß des p-Kanal-Bypaßtransistors BT. Hierdurch ist eine besonders einfache Realisierung des Bypaßtransistors, wie bereits bei der Beschreibung der Fig. 2 erwähnt, gewährleistet, indem für den Bypaßtransistor lediglich eine zusätzliche p⁺-Diffusion für das p⁺-dotierte Halbleitergebiet P3 und ein zusätzliches Gategebiet GB aufgebaut werden muß.

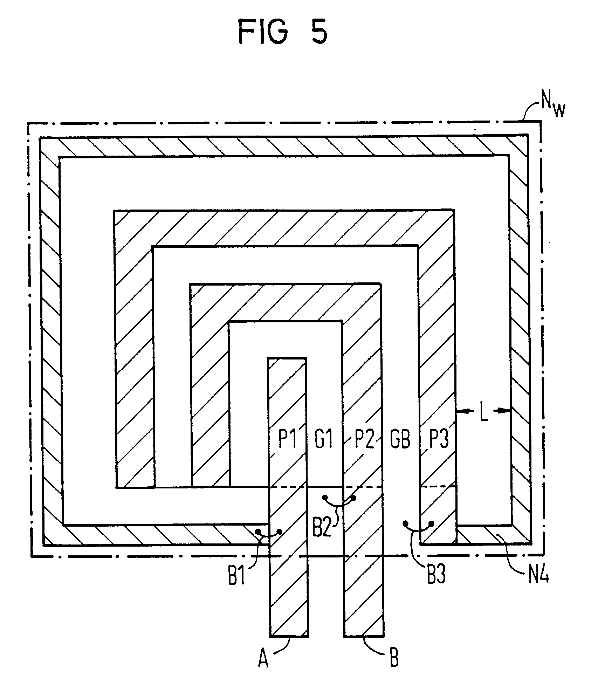

Eine Realisierung durch ein Layout einer als Diode oder Lastelement beschalteten p-Kanal-MOS-Transistors T1 mit einem Bypaßtransistor BT nach der in Fig. 3 und 4 angegebenen Schaltung ist in Fig. 5 als Ansicht von oben dargestellt. Zur Vermeidung von parasitären Zuleitungskapazitäten sind die Gategebiete G1 und GB sowie die p⁺-dotierten Halbleitergebiete P2 und P3 U-förmig um das p⁺-dotierte Halbleitergebiet P1 angeordnet. Die in Fig. 3 und Fig. 4 gewählten Bezugszeichen sind ebenfalls in Fig. 5 verwendet, um zu verdeutlichen, wo die Einzelheiten des p-Kanal-MOS-Transistors T1 und des p-Kanal-Bypaßtransistors BT nach Fig. 3 und Fig. 4 im Layout der Fig. 5 angeordnet sind. Aus der Draufsicht nach Fig. 5 erkennt man das p⁺-dotierte Halbleitergebiet P1, das Gategebiet G1 und das p⁺-dotierte Halbleitergebiet P2, welche den p-Kanal-MOS-Transistor T1 bilden, wobei das p⁺-dotierte Halbleitergebiet P2 ebenfalls gemeinsam mit dem Gategebiet GB und dem p⁺-dotierten Halbleitergebiet P3 den p-Kanal-Bypaßtransistor BT darstellen. Nach Fig. 5 ist das p⁺-dotierte Halbleitergebiet P1, der als erster Anschluß des p-Kanal-Feldeffekttransistors T1 Verwendung findet, streifenförmig aufgebaut und mit der Klemme A verbunden. Das zum p-Kanal-Feldeffekttransistor T1 gehörende Gategebiet G1 sowie der zweite Anschluß des Feldeffekttransistors T1, der durch das p⁺-dotierte Halbleitergebiet P2 verdeutlicht ist, sind jeweils U-förmig um das p⁺-dotierte Halbleitergebiet P1 angeordnet. Hierbei ist der zweite Anschluß des p-Kanal-Feldeffekttransistors T1 mit der Klemme B und über eine elektrische Verbindung B2 mit dem Gategebiet G1 verbunden. Die U-förmige Anordnung des Gategebiets G1 und des p⁺-dotierten Halbleitergebiets P2 ist so ausgestaltet, daß zunächst das Gategebiet G1 um das p⁺-dotierte Halbleitergebiet P1 angeordnet ist, und um das Gategebiet G1 das p⁺-dotierte Halbleitergebiet P2 liegt, wobei das Gategebiet G1 über einer durch die p⁺-dotierten Halbleitergebiete P1, P2 und P3 fiktiv aufgespannten Ebene angeordnet und zu dem p⁺-dotierten Halbleitergebiet P1 und P2 durch eine dünne Isolationsschicht getrennt ist. Um das p⁺-dotierte Halbleitergebiet P2, welches als zweiter Anschluß für den p-Kanal-Feldeffekttransistors T1 und für den p-Kanal-Bypaßtransistor BT genutzt wird, ist das Gategebiet GB und um dieses das p⁺-dotierte Halbleitergebiet P3 aufgebaut. Als Gatematerial für beide Gategebiete G1 und GB kann beispielsweise Polysilizium verwendet werden. Das p⁺-dotierte Halbleitergebiet P3, welches auch den ersten Anschluß des p-Kanal-Bypaßtransistors BT darstellt, ist über eine weitere elektrische Verbindung B3 mit dem Gategebiet GB des p-Kanal-Bypaßtransistors BT verbunden. Wiederum ist das Gategebiet GB über einer durch die p⁺-dotierten Halbleitergebiete P1, P2 und P3 fiktiv aufgespannten Ebene angeordnet und zu den p⁺-dotierten Halbleitergebieten P2 und P3 durch eine dünne Isolationsschicht getrennt. Die Darstellung nach Fig. 5 zeigt weiterhin, daß das n⁺-dotierte Halbleitergebiet N4 streifenförmig um das p⁺-dotierte Halbleitergebiet P3 in einem frei wählbaren Abstand L angeordnet und über eine elektrische Verbindung B1 mit der Klemme A verbunden ist. Nach Fig. 4 stellt das n⁺-dotierte Halbleitergebiet N4 einen elektrischen Kontakt zur n-dotierten wannenförmigen Halbleiterzone N_{w} dar, die nach Fig. 5 gestrichelt außerhalb der n⁺-dotierten Halbleiterzone N4 angedeutet ist.

Neben den oben behandelten Ausführungsformen umfaßt die Erfindung auch solche, bei denen n-leitendes Substrat mit p-leitenden wannenförmigen Halbleiterzonen versehen sind. Dabei werden die Leitungstypen sämtlicher Halbleiterteile und die Polarisation sämtlicher Spannungen durch die jeweils entgegengesetzten ersetzt.

## Patentansprüche

1. Integrierte Schaltung mit "Latch-up"-Schutzschaltung in komplementärer MOS-Schaltungstechnik mit einem dotierten Halbleitersubstrat (P_{sub}) eines ersten Leitungstyps in das eine wannenförmige Halbleiterzone (N_{w}) eines zweiten Leitungstyps eingefügt ist, mit einem ersten Feldeffekttransistor (T1) innerhalb der wanneförmigen Halbleiterzone und einem zweiten Feldeffekttransistor (T2) außerhalb der wannenförmigen Halbleiterzone, bei der die "Latch-up"-Schutzschaltung einen Bypaßtransistor (BT) enthält, bei der ein Gateanschluß und ein erster Anschluß des Bypaßtransistors mit einer Klemme (KL) verbunden sind und ein zweiter Anschluß des Bypaßtransistors mit einem Ausgang der integrierten Schaltung (OUT) verbunden ist,
**dadurch gekennzeichnet,**
daß der Bypaßtransistor (BT) innerhalb der wannenförmigen Halbleiterzone vorgesehen ist und eine Durchlaßspannung aufweist, die geringer ist als die Durchlaßspannung der pn-Übergänge des ersten Feldeffekttransistors (T1).

2. Integrierte Schaltung mit "Latch-up"-Schutzschaltung nach Anspruch 1, **dadurch gekennzeichnet,** daß der Bypaßtransistor (BT) ein p-Kanal-Feldeffekttransistor ist, daß das dotierte Halbleitersubstrat eines ersten Leitungstyps p-dotiert ist, daß die wannenförmige Halbleiterzone eines zweiten Leitungstyps n-dotiert ist und daß die Klemme (KL) und die wannenförmige Halbleiterzone eines zweiten Leitungstyps (N_{w}) mit der Versorgungsspannung (V_{DD}) beschaltet ist.

3. Integrierte Schaltung mit "Latch-up"-Schutzschaltung nach Anspruch 1, **dadurch gekennzeichnet,** daß der Bypaßtransistor ein n-Kanal-Feldeffekttransistor ist, daß das dotierte Halbleitersubstrat eines ersten Leitungstyps n-dotiert ist, daß die wannenförmige Halbleiterzone eines zweiten Leitungstyps p-dotiert ist und daß die Klemme (KL) und die wannenförmige Halbleiterzone eines zweiten Leitungstyps mit der Masse (V_{SS}) verschaltet ist.

4. Integrierte Schaltung mit "Latch-up"-Schutzschaltung nach Anspruch 1, **dadurch gekennzeichnet,** daß der Bypaßtransistor (BT) ein p-Kanal-Feldeffekttransistor ist, daß das dotierte Halbleitersubstrat eines ersten Leitungstyps p-dotiert ist, die wannenförmige Halbleiterzone eines zweiten Leitungstyps n-dotiert ist und daß die Klemme (KL) und die wannenförmige Halbleiterzone eines zweiten Leitungstyps mit einer variablen Spannung beschaltet ist.

5. Integrierte Schaltung mit "Latch-up"-Schutzschaltung nach Anspruch 1, **dadurch gekennzeichnet,** daß der Bypaßtransistor ein n-Kanal-Feldeffekttransistor ist, daß das dotierte Halbleitersubstrat eines ersten Leitungstyps n-dotiert ist, daß die wannenförmige Halbleiterzone eines zweiten Leitungstyps p-dotiert ist und daß die Klemme und die wannenförmige Halbleiterzone eines zweiten Leitungstyps mit einer variablen Spannung beschaltet ist.

6. Integrierte Schaltung mit "Latch-up"-Schutzschaltung nach einem der Ansprüche 1 bis 5, **dadurch gekennzeichnet,** daß der zweite Anschluß (P2) des Bypaßtransistors (BT) durch ein Halbleitergebiet, der einen Anschluß eines Feldeffekttransistors der integrierten Schaltung darstellt, realisiert ist.

7. Integrierte Schaltung mit "Latch-up"-Schutzschaltung nach einem der Ansprüche 1 bis 6, **dadurch gekennzeichnet,** daß der erste Anschluß des Bypaßtransistors durch eine streifenförmige Halbleiterzone (P1) eines ersten Leitungstyps und der zweite Anschluß durch eine die streifenförmige Halbleiterzone (P1) umgebende Halbleiterzone (P2) eines ersten Leitungstyps realisiert ist, daß zwischen der streifenförmigen Halbleiterzone eines ersten Leitungstyps (P1) und der Halbleiterzone eines ersten Leitungstyps (P2) ein Abstand, der der Breite eines Gates eines Feldeffekttransistors entspricht, vorhanden ist, und daß der Gateanschluß (GB) durch ein Gatematerial, das isoliert oberhalb des ersten und zweiten Anschlußes des Bypaßtransistors angeordnet ist, aufgebaut ist.

## Claims

1. Integrated circuit with latch-up protection circuit in complementary MOS circuit technology, with a doped semiconductor substrate (P_{sub}) of a first tee of conductivity into which a well-shaped semiconductor zone (N_{w}) of a second tee of conductivity is inserted, with a first field-effect transistor (T1) inside the well-shaped semiconductor zone and a second field-effect transistor (T2) outside the well-shaped semiconductor zone, in which the latch-up protection circuit contains a bypass transistor (BT), in which a gate terminal and a first terminal of the brass transistor are connected to a terminal (KL) and a second terminal of the brass transistor is connected to an output of the integrated circuit (OUT), characterized in that the bypass transistor (BT) is provided inside the well-shaped semiconductor zone and exhibits a forward voltage which is lower than the forward voltage of the pn junctions of the first field-effect transistor (T1).

2. Integrated circuit with latch-up protection circuit according to Claim 1, characterized in that the bypass transistor (BT) is a p-channel field-effect transistor, in that the doped semiconductor substrate of a first type of conductivity is p-doped, in that the well-shaped semiconductor zone of a second type of conductivity is n-doped and in that the terminal (KL) and the well-shaped semiconductor zone of a first type of conductivity (N_{w}) is connected to the supply voltage (V_{DD}).

3. Integrated circuit with latch-up protection circuit according to Claim 1, characterized in that the bypass transistor is an n-channel field-effect transistor, in that the doped semiconductor substrate of a first type of conductivity is n-doped, in that the well-shaped semiconductor zone of a second type of conductivity is p-doped and in that the terminal (KL) and the well-shaped semiconductor zone of a second type of conductivity is connected to earth (V_{SS}).

4. Integrated circuit with latch-up protection circuit according to Claim 1, characterized in that the bypass transistor (BT) is a p-channel field-effect transistor, in that the doped semiconductor substrate of a first type of conductivity is p-doped, the well-shaped semiconductor zone of a second type of conductivity is n-doped and in that the terminal (KL) and the well-shaped semiconductor zone of a second type of conductivity is connected to a variable voltage.

5. Integrated circuit with latch-up protection circuit according to Claim 1, characterized in that the bypass transistor is an n-channel field-effect transistor, in that the doped semiconductor substrate of a first type of conductivity is n-doped, in that the well-shaped semiconductor zone of a second type of conductivity is p-doped and in that the terminal and the well-shaped semiconductor zone of a second type of conductivity is connected to a variable voltage.

6. Integrated circuit with latch-up protection circuit according to one of Claims 1 to 5, characterized in that the second terminal (P2) of the bypass transistor (BT) is implemented by a semiconductor region which represents a terminal of a field-effect transistor of the integrated circuit.

7. Integrated circuit with latch-up protection circuit according to one of Claims 1 to 6, characterized in that the first terminal of the bypass transistor is implemented by a strip-shaped semiconductor zone (P1) of a first type of conductivity and the second terminal is implemented by a semiconductor zone (P2) of a first type of conductivity surrounding the strip-shaped semiconductor zone (P1), in that a distance which corresponds to the width of a gate of a field-effect transistor exists between the strip-shaped semiconductor zone of a first type of conductivity (P1) and the semiconductor zone of a first type of conductivity (P2), and in that the gate terminal (GB) is built up by a gate material which is arranged insulated above the first and second terminal of the bypass transistor.

## Revendications

1. Circuit intégré comportant un circuit de protection vis-à-vis de l'effet "Latch-up" en technique des circuits MOS complémentaires et comportant un substrat semiconducteur dopé (P_{sub}) d'un premier type de conductivité dans lequel est insérée une zone semiconductrice en forme de cuvette (N_{w}) d'un second type de conductivité, et comportant un premier transistor à effet de champ (T1) situé à l'intérieur de la zone semiconductrice en forme de cuvette, et un second transistor à effet de champ (T2) situé à l'extérieur de la zone semiconductrice en forme de cuvette, circuit dans lequel le circuit de protection vis-à-vis de l'effet "Latch-up" comporte un transistor de dérivation (BT), une borne de grille et une première borne du transistor de dérivation étant reliées à une borne (KL), tandis qu'une seconde borne du transistor de dérivation est reliée à une sortie du circuit intégré (OUT),
caractérisé par le fait que le transistor de dérivation (BT) est à l'intérieur de la zone semiconductrice en forme de cuvette et présente une tension de claquage, qui est inférieure à la tension de claquage des jonctions pn du premier transistor à effet de champ (T1).

2. Circuit intégré comportant un circuit de protection vis-à-vis de l'effet "Latch-up" suivant la revendication 1, caractérisé par le fait que le transistor de dérivation (BT) est un transistor à effet de champ à canal p, que le substrat semiconducteur dopé d'un premier type de conductivité est dopé du type p, que la zone semiconductrice en forme de cuvette du second type de conductivité est dopée du type n, et que la borne (KL) et la zone semiconductrice en forme de cuvette d'un second type de conductivité (N_{w}) sont reliées à la tension d'alimentation (V_{DD}).

3. Circuit intégré comportant un circuit de protection vis-à-vis de l'effet "Latch-up" suivant la revendication 1, caractérisé par le fait que le transistor de dérivation est un transistor à effet de champ à canal n, que le substrat semiconducteur dopé d'un premier type de conductivité est dopé de type n, que la zone semiconductrice en forme de cuvette d'un second type de conductivité est dopée du type p, et que la borne (KL) et la zone semiconductrice en forme de cuvette d'un second type de conductivité sont reliées à la masse (V_{SS}).

4. Circuit intégré comportant un circuit de protection vis-à-vis de l'effet "Latch-up" suivant la revendication 1, caractérisé par le fait que le transistor de dérivation (BT) est un transistor à effet de champ à canal p, que le substrat semiconducteur dopé d'un premier type de conductivité est dopé de type p, que la zone semiconductrice en forme de cuvette d'un second type de conductivité est dopée de type n, et que la borne (KL) et la zone semiconductrice en forme de cuvette d'un second type de conductivité sont reliées à une tension variable.

5. Circuit intégré comportant un circuit de protection vis-à-vis de l'effet "Latch-up" suivant la revendication 1, caractérisé par le fait que le transistor de dérivation est un transistor à effet de champ à canal n, que le substrat semiconducteur dopé d'un premier type de conductivité est dopé de type n, que la zone semiconductrice en forme de cuvette d'un second type de conductivité est dopée de type p et que la borne et la zone semiconductrice en forme de cuvette d'un second type de conductivité sont reliées à une tension variable.

6. Circuit intégré comportant un circuit de protection vis-à-vis de l'effet "Latch-up" suivant l'une des revendications 1 à 5, caractérisé par le fait que la seconde borne (P2) du transistor de dérivation (BT) est constituée par une région semiconductrice, qui représente une borne d'un transistor à effet de champ du circuit intégré.

7. Circuit intégré comportant un circuit de protection vis-à-vis de l'effet "Latch-up" suivant l'une des revendications 1 à 6, caractérisé par le fait que la première borne du transistor de dérivation est constituée par une zone semiconductrice (P1) en forme de bande et d'un premier type de conductivité et que la seconde borne est constituée par une zone semiconductrice (P2) d'un premier type de conductivité, qui entoure la zone semiconductrice (P1) en forme de bande, qu'entre la zone semiconductrice (P1) en forme de bande et d'un premier type de conductivité et la zone semiconductrice (P2) d'un second type de conductivité existe une distance qui correspond à la largeur d'une grille d'un transistor à effet de champ, et que la borne de grille (GB) est en un matériau qui est disposé d'une manière isolée au-dessus des première et seconde bornes du transistor de dérivation.
